(19) Europäisches Patentamt / European Patent Office / Office européen des brevets

(11) **EP 4 498 591 B1**

(12) **EUROPEAN PATENT SPECIFICATION**

(45) Date of publication and mention
of the grant of the patent:
**29.04.2026  Bulletin 2026/18**

(21) Application number: **23795846.7**

(22) Date of filing: **07.02.2023**

(51) International Patent Classification (IPC):
*H02M 7/00* (2006.01)     *H01G 4/228* (2006.01)
*H01G 4/40* (2006.01)     *H01L 23/498* (2006.01)
*H01L 25/07* (2006.01)

(52) Cooperative Patent Classification (CPC):
**H02M 7/003; H01G 4/228; H01G 4/40;
H10W 90/701;** H10W 90/00

(86) International application number:
**PCT/JP2023/003986**

(87) International publication number:
**WO 2023/210098 (02.11.2023 Gazette 2023/44)**

(54) **POWER CONVERSION DEVICE**

LEISTUNGSWANDLER

DISPOSITIF DE CONVERSION DE PUISSANCE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **28.04.2022  JP 2022075380**

(43) Date of publication of application:
**29.01.2025  Bulletin 2025/05**

(73) Proprietor: **Mitsubishi Heavy Industries, Ltd.
Tokyo 100-8332 (JP)**

(72) Inventor: **MASUZAWA, Takashi
Tokyo 100-8332 (JP)**

(74) Representative: **Studio Torta S.p.A.
Via Viotti, 9
10121 Torino (IT)**

(56) References cited:
**WO-A1-2021/044490     DE-A1- 102015 118 591
JP-A- 2004 165 309     JP-A- H1 155 938
US-A1- 2013 264 891**

## Description

The present invention relates to a power conversion device.

Priority is claimed by the present application on JP 2022-75380, filed Apr. 28, 2022.

### Background Art

For example, Patent Document 1 discloses a power conversion device in which a positive electrode side conductor and a negative electrode side conductor each connected to a capacitor are stacked in a laminate structure sandwiching an insulating layer therebetween.

The positive electrode side conductor and the negative electrode side conductor as connection conductors both have a flat plate shape and are opposed in a state of being parallel to each other with the insulating layer therebetween.

Accordingly, when a current flows through the positive electrode side conductor and the negative electrode side conductor, magnetic fluxes generated in the positive electrode side conductor and the negative electrode side conductor cancel each other, and as a result, parasitic inductance is reduced.

For example, Patent Document 2 discloses a semiconductor device including a main terminal group as a connection conductor configured by continuously arranging three or more main terminals.

In the main terminal group, a main terminal as a collector terminal connected to a collector electrode of a semiconductor chip and a main terminal as an emitter terminal connected to an emitter electrode of the semiconductor chip are alternately arranged in a state of being adjacent to each other.

That is, side surface facing portions of the main terminals are arranged in parallel.

Accordingly, since the side surfaces of the plurality of collector terminals and the emitter terminals are opposed to each other, when a main current flows through the collector terminals and the emitter terminals, magnetic fluxes generated in the collector terminals and the emitter terminals cancel each other, and as a result, the parasitic inductance is reduced.

### Citation List

### Patent Literature

Patent Document 1: JP2002-119069 A
Patent Document 2: WO 2020/021881 A

### Summary of Invention

### Technical Problem

In recent years, in the field of a power conversion device including a power semiconductor element, there has been an increasing trend toward higher voltage, larger current, higher frequency, and faster switching in order to improve added value.

Accordingly, it is desired to further reduce parasitic inductance generated in a connection conductor.

In the laminate structure in the power conversion device described in Patent Document 1, there is a high risk of dielectric breakdown occurring in the insulating layer sandwiched between the positive electrode side conductor and the negative electrode side conductor.

When the thickness of the insulating layer is increased for the purpose of avoiding the dielectric breakdown of the insulating layer, an interaction that cancels the magnetic fluxes between the positive electrode side conductor and the negative electrode side conductor each other may be reduced.

In the semiconductor device described in Patent Document 2, among the surfaces of the main terminals, the side surfaces each having a relatively small area are opposed to each other.

Therefore, for example, as compared with the arrangement of the positive electrode side conductor and the negative electrode side conductor described in Patent Document 1, the magnetic fluxes generated in the main terminals may not smoothly cancel each other.

For example, in a case where the main terminal is formed or disposed to be thick so that the area of the opposing surface is increased, the main terminal may be increased in size and weight.

The present invention has been made to solve the above problem, and an object of the present invention is to provide a power conversion device that can reduce parasitic inductance generated in a connection conductor while suppressing an increase in size and weight of the connection conductor.

### Solution to Problem

In order to solve the above problem, a power conversion device according to claim 1 is proposed. It includes a capacitor to which DC power is supplied, a power module configured to convert a DC voltage from the capacitor into an AC voltage and output the AC voltage, and a connection conductor including a positive electrode-side busbar configured to connect the capacitor and a P-type terminal of the power module and a negative electrode-side busbar having a shape identical to a shape of the positive electrode-side busbar, symmetrically arranged side by side with the positive electrode-side busbar in pairs with a gap therebetween, and configured to connect the capacitor and an N-type terminal of the power module. The positive electrode-side busbar includes a first main body portion including a first bottom surface abutting on the P-type terminal and a first opposing surface rising from the first bottom surface and a first cutout portion disposed in at least part of the first main body portion on a side opposite to the first bottom surface and the first opposing surface. The negative electrode-side busbar includes a second main body portion including a second bottom surface abutting on the N-type terminal and a second opposing surface rising from the second bottom surface and disposed in parallel to and opposed to the first opposing surface with a gap therebetween and a second cutout portion disposed in part of the second main body portion on a side opposite to the second bottom surface and the second opposing surface. The connection conductor includes a plurality of pairs of the positive electrode-side busbar and the negative electrode-side busbar, and the plurality of pairs of the positive electrode-side busbar and the negative electrode-side busbar are arranged side by side at equal intervals in a direction in which the first opposing surface and the second opposing surface are opposed to each other.

Advantageous Effects of Invention

According to the present invention, a power conversion device that can reduce parasitic inductance generated in a connection conductor while suppressing an increase in size and weight of the connection conductor can be provided.

Brief Description of Drawings

FIG. 1 is a perspective view illustrating a schematic configuration of a power conversion device according to an embodiment which does not form part of the claimed invention but is useful for understanding it.
FIG. 2 is an enlarged perspective view of a main part of the power conversion device illustrated in FIG. 1.
FIG. 3 is a cross-sectional view taken along line III-III illustrated in FIG. 2.
FIG. 4 is a cross-sectional view of a connection conductor according to another embodiment which does not form part of the claimed invention but is useful for understanding it, corresponding to the portion illustrated in FIG. 3.
FIG. 5 is a cross-sectional view of a connection conductor according to another embodiment which does not form part of the claimed invention but is useful for understanding it, corresponding to the portion illustrated in FIG. 3.
FIG. 6 is a cross-sectional view of a connection conductor according to another embodiment which does not form part of the claimed invention but is useful for understanding it, corresponding to the portion illustrated in FIG. 3.
FIG. 7 is an enlarged perspective view illustrating a main part of the power conversion device according to another embodiment, which is in accordance with the claimed invention.
FIG. 8 is a cross-sectional view taken along line VIII-VIII illustrated in FIG. 7.

Description of Embodiments

Hereinafter, embodiments for implementing a power conversion device according to the present disclosure will be described with reference to the accompanying drawings.

Power Conversion Device

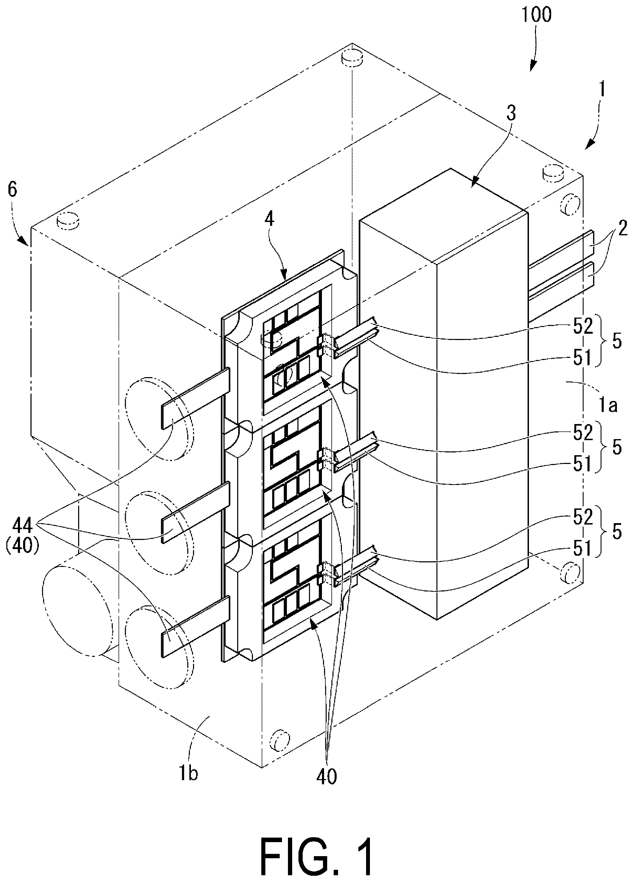

The power conversion device is a device that converts DC power into AC power, converts AC power into DC power, or converts DC power into DC power having a different potential.
Examples of the power conversion device of the present embodiment include an inverter used in a system of a power plant or the like, an inverter used for driving an electric motor of an electric vehicle, or the like.
In the present embodiment, an inverter for controlling an electric motor (motor) will be described as an example of the power conversion device.
As illustrated in FIG. 1, a power conversion device 100 includes a casing 1, an external input conductor 2, a capacitor 3, a power conversion unit 4, a cooling device 6, and a connection conductor 5.

Casing

The casing 1 forms an outer shell of the power conversion device 100.
The casing 1 in the present embodiment is made of a metal such as aluminum, a synthetic resin, or the like, and has a rectangular parallelepiped shape.
The casing 1 includes two side surfaces arranged so as to be back-to-back with each other.
Hereinafter, among these two side surfaces, a side surface opposing one side is referred to as an "input-side side surface 1a", and a side surface opposing the other side is referred to as an "output-side side surface 1b".
The external input conductor 2 for inputting DC power is led out from the input-side side surface 1a.

External Input Conductor

The external input conductors 2 are a pair of electrical conductors (busbars) that supply DC power supplied from a DC power supply or the like provided outside the power conversion device 100 to the capacitor 3.
The external input conductor 2 in the present embodiment is made of a metal including copper or the like.
One end of the external input conductor 2 is connected to the capacitor 3, and the other end of the external input conductor 2 extends in a direction intersecting the input-side side surface 1a of the casing 1.

Capacitor

The capacitor 3 is a smoothing capacitor for storing electric charge input from the external input conductor 2 and suppressing voltage fluctuation associated with power conversion.

The DC voltage smoothed by suppressing ripples through the capacitor 3 is supplied to the power conversion unit 4.

Power Conversion Unit

The power conversion unit 4 converts the voltage input from the capacitor 3.

In order to output three-phase AC power, the power conversion unit 4 in the present embodiment includes three power modules 40 responsible for outputs for the U phase, the V phase, and the W phase, respectively.

Power Module

The power module 40 is a device that converts input power and outputs the converted power.

The power module 40 in the present embodiment constitutes a part of the power conversion unit 4.

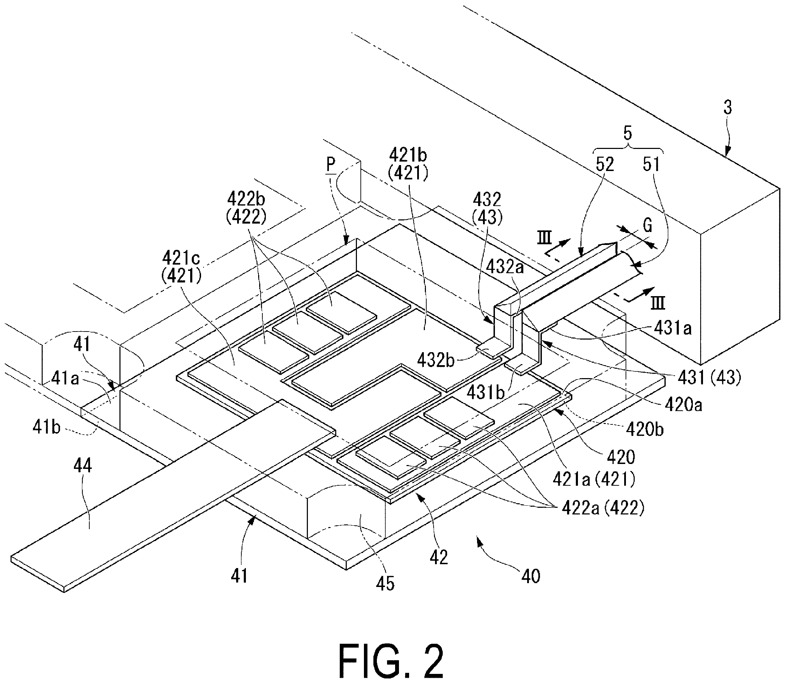

As illustrated in FIG. 2, the power module 40 includes a base plate 41, a circuit board 42, a main terminal portion 43, an external output conductor 44, and a reinforcing portion 45.

The base plate 41 is a member having a flat plate shape.

The base plate 41 includes a main surface 41a and a back surface 41b located on the back side of the main surface 41a.

That is, the main surface 41a and the back surface 41b of the base plate 41 are back-to-back in a state of being parallel to each other.

The back surface 41b of the base plate 41 is fixed to, for example, the cooling device 6 with a bonding material or the like (not illustrated) therebetween.

The base plate 41 in the present embodiment is made of, for example, copper.

The base plate 41 may be made of a metal other than copper.

The circuit board 42 includes an insulating plate 420, a front surface pattern 421, a power semiconductor element 422, and a back surface pattern (not illustrated for convenience of illustration).

The insulating plate 420 has a flat plate shape.

The insulating plate 420 includes a first surface 420a and a second surface 420b located on the back side of the first surface 420a.

That is, the first surface 420a and the second surface 420b of the insulating plate 420 are back-to-back in a state of being parallel to each other.

A back surface pattern, which is a pattern of copper foil or the like, is formed on the second surface 420b of the insulating plate 420.

The back surface pattern is fixed to the center of the main surface 41a of the base plate 41 with a bonding material or the like (not illustrated) therebetween.

The insulating plate 420 is made of an insulating material such as ceramic.

In addition to ceramic, paper phenol, paper epoxy, glass composite, glass epoxy, glass polyimide, fluororesin, or the like can be used as the insulating material forming the insulating plate 420.

The front surface pattern 421 is a pattern of copper foil or the like formed on the first surface 420a of the insulating plate 420 and extending in a planar shape.

The front surface pattern 421 is formed by, for example, being fixed to the first surface 420a of the insulating plate 420 by adhesion or the like and then being etched or the like.

A plurality of the front surface patterns 421 are disposed on the first surface 420a of the insulating plate 420.

The plurality of front surface patterns 421 are arranged adjacent to each other with a gap therebetween in a direction in which the insulating plate 420 extends.

In the present embodiment, a case where three front surface patterns 421 are arranged on the first surface 420a will be described as an example.

Hereinafter, for convenience of description, these three front surface patterns 421 are referred to as a first front surface pattern 421a, a second front surface pattern 421b, and a third front surface pattern 421c.

The main terminal portion 43 (P-type terminal 431) as a positive electrode for inputting a direct current is connected to the first front surface pattern 421a.

The main terminal portion 43 (N-type terminal 432) as a negative electrode for outputting a direct current is connected to the second front surface pattern 421b.

That is, the first front surface pattern 421a corresponds to an inlet portion of a loop between P and N formed in the front surface pattern 421, and the second front surface pattern 421b corresponds to an outlet portion of the loop between P and N.

The external output conductor 44 for outputting an alternating current converted by the power semiconductor element 422 to a load such as a motor (not illustrated) provided outside the power conversion device 100 is connected to the third front surface pattern 421c.

The power semiconductor element 422 is a circuit element that converts power by a switching operation of turning on and off a voltage or a current.

The power semiconductor element 422 is, for example, a switching element such as an IGBT or a MOSFET.

In the present embodiment, as an example, six power semiconductor elements 422 are connected to the front surface pattern 421 on the circuit board 42.

The six power semiconductor elements 422 in the present embodiment include three first power semiconductor elements 422a and three second power semiconductor elements 422b.

The first power semiconductor element 422a is connected to the first front surface pattern 421a.

The second power semiconductor element 422b is connected to the third front surface pattern 421c.

When the power semiconductor element 422 is the IGBT, the power semiconductor element 422 includes an input surface on which an input terminal corresponding to a collector is formed, an output surface on which an output terminal corresponding to an emitter is formed, and a gate corresponding to a control signal input terminal for controlling switching of the power semiconductor element 422.

The input surface of the power semiconductor element 422 is electrically connected to the front surface pattern 421 with a bonding material or the like (not illustrated) therebetween.

For example, one end of a bonding wire (not illustrated) as a conducting wire is electrically connected to the output surface of the power semiconductor element 422.

The input surface of the first power semiconductor element 422a is connected to the first front surface pattern 421a.

The other end of the bonding wire connected to the output surface of the first power semiconductor element 422a is connected to the third front surface pattern 421c.

The input surface of the second power semiconductor element 422b is connected to the third front surface pattern 421c.

The other end of the bonding wire connected to the output surface of the second power semiconductor element 422b is connected to the second front surface pattern 421b.

DC power is input to the input terminal of the first power semiconductor element 422a through the first front surface pattern 421a, and the input DC power is converted into AC power by the first power semiconductor element 422a.

The converted AC power is output from an output terminal (not illustrated) in the first power semiconductor element 422a to the third front surface pattern 421c through a bonding wire.

AC power is input to the input terminal of the second power semiconductor element 422b through the third front surface pattern 421c, and the input AC power is converted into DC power by the second power semiconductor element 422b.

The converted DC power is output from an output terminal (not illustrated) in the second power semiconductor element 422b to the second front surface pattern 421b through a bonding wire.

A control signal generated by a control unit (not illustrated) provided outside the circuit board 42 is input to the power semiconductor element 422.

The power semiconductor element 422 performs switching in accordance with the control signal.

When the power semiconductor element 422 is the MOSFET, the power semiconductor element 422 includes an input surface corresponding to a drain, an output surface corresponding to a source, and a gate corresponding to a control signal input terminal.

For example, solder, a sintered material (powder of a metal or the like), or the like can be adopted as the above-described bonding material used for bonding the base plate 41 and the back surface pattern formed on the second surface 420b of the insulating plate 420 to each other, bonding the power semiconductor element 422 and the front surface pattern 421 to each other, and bonding the back surface 41b of the base plate 41 and the cooling device 6 to each other.

The main terminal portion 43 is an electric conductor (busbar) that exchanges DC power between the capacitor 3 and the circuit board 42.

The main terminal portion 43 is made of a metal such as copper.

The main terminal portion 43 includes the P-type terminal 431 as the positive electrode and the N-type terminal 432 as the negative electrode.

The P-type terminal 431 and the N-type terminal 432 are arranged side by side with a gap therebetween.

In other words, the N-type terminal 432 is arranged side by side with the P-type terminal 431 with a gap therebetween.

The P-type terminal 431 and the N-type terminal 432 have the same size and shape.

The term "same" in the present embodiment refers to a substantially same state, and a slight manufacturing error and a design tolerance are allowed.

The P-type terminal 431 includes one end portion 431b connected to the first front surface pattern 421a, and the other end portion 431a which extends integrally with the one end portion 431b from the one end portion 431b and into which a direct current from the positive electrode of the capacitor 3 flows.

The other end portion 431a of the P-type terminal 431 has a flat plate shape.

The N-type terminal 432 includes one end portion 432b connected to the second front surface pattern 421b and the other end portion 432a extending integrally with the one end portion 432b from the one end portion 432b and allowing a direct current to flow out toward the negative electrode of the capacitor 3.

The other end portion 432a of the N-type terminal 432 has a flat plate shape.

The external output conductor 44 is an electrical conductor (busbar) for outputting the AC power converted by the power semiconductor element 422 to the outside of the power conversion device 100.

The external output conductor 44 is made of a metal including copper or the like.

One end of the external output conductor 44 is connected to the third front surface pattern 421c on the circuit board 42.

As illustrated in FIG. 1, the other end of the external output conductor 44 extends outward beyond the output-side side surface 1b of the casing 1.

A wiring (not illustrated) for current output connected to a load such as a motor is connected to the other end of the external output conductor 44, for example.

As indicated by a two-dot chain line in FIG. 2, the reinforcing portion 45 is a member that is fixed to the main surface 41a of the base plate 41 and mechanically reinforces the main terminal portion 43 and the external output conductor 44.

The reinforcing portion 45 is made of a synthetic resin material or the like.

The reinforcing portion 45 covers the main terminal portion 43 and the external output conductor 44 from the outside and surrounds the circuit board 42 from the outside.

The reinforcing portion 45 forms a case surrounding the circuit board 42 from the periphery in a direction along the main surface 41a of the base plate 41.

Therefore, the reinforcing portion 45 defines a space in which the circuit board 42 is accommodated together with the base plate 41.

The reinforcing portion 45 is fixed to the first surface 420a of the base plate 41 with an adhesive or the like therebetween.

For example, an insulating material such as polyphenylene sulfide (PPS) can be adopted as the synthetic resin material for the reinforcing portion 45 in the present embodiment.

An insulating material other than PPS may be used for the reinforcing portion 45.

Hereinafter, in the present embodiment, the space defined by the reinforcing portion 45 and the base plate 41 is referred to as a potting space P.

A liquid potting material (not illustrated) is poured (potting) into the potting space P from the outside, and the front surface pattern 421 on the circuit board 42 and the power semiconductor element 422 each exposed to the potting space P are sealed.

The potting material poured into the potting space P is cured over a predetermined time, and electrically insulates the front surface pattern 421 on the circuit board 42 and the power semiconductor element 422 from a space outside the power module 40.

As the potting material in the present embodiment, for example, silicone gel, an epoxy resin, or the like is adopted.

A synthetic resin other than the silicone gel and the epoxy resin may be used as the potting material.

Cooling Device

As illustrated in FIG. 1, the cooling device 6 is a device that mainly cools the power module 40 of the power conversion unit 4.

The cooling device 6 is provided so as to be stacked on the casing 1, and is fixed to and integrated with the casing 1.

A liquid refrigerant such as water is introduced into the cooling device 6 from the outside.

The liquid refrigerant exchanges heat with the power module 40 and is heated, thereby cooling the power module 40.

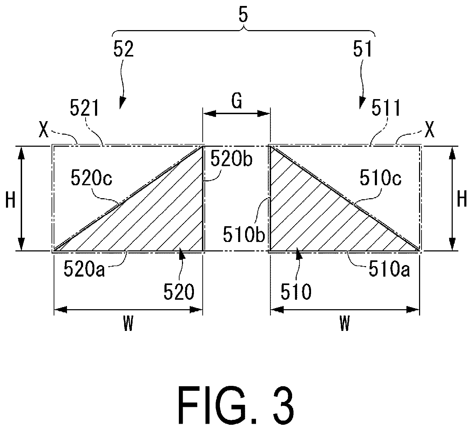

Hereinafter, the configuration of the connection conductor 5 that relays DC power between the capacitor 3 and the power module 40 will be described with reference to FIGS. 2 and 3.

Connection Conductor

The connection conductor 5 is an electrical conductor (busbar) made of a metal including copper or the like.

In the present embodiment, three connection conductors 5 are arranged at intervals so as to correspond to the power modules 40. respectively.

In the present embodiment, which does not form part of the claimed invention, each connection conductor 5 includes a positive electrode-side busbar 51 and a negative electrode-side busbar 52.

The positive electrode-side busbar 51 is a current path that connects the positive electrode of the capacitor 3 and the power module 40.

The negative electrode-side busbar 52 is a current path that connects the negative electrode of the capacitor 3 and the power module 40.

The positive electrode-side busbar 51 and the negative electrode-side busbar 52 are arranged side by side at an interval.

One end of each of the positive electrode-side busbar 51 and the negative electrode-side busbar 52 is connected to the capacitor 3.

A detailed illustration of connection states between the positive electrode-side busbar 51 and the capacitor 3 and between the negative electrode-side busbar 52 and the capacitor 3 are omitted.

The other end of the positive electrode-side busbar 51 is connected to the P-type terminal 431 in the power module 40.

The other end of the negative electrode-side busbar 52 is connected to the N-type terminal 432 of the power module 40.

The positive electrode-side busbar 51 and the negative electrode-side busbar 52 have the same size and shape.

The positive electrode-side busbar 51 and the negative electrode-side busbar 52 in the present embodiment are symmetrically arranged side by side to form a pair.

Hereinafter, an interval generated between the positive electrode-side busbar 51 and the negative electrode-side busbar 52 by being arranged side by side is referred to as a "gap G".

In other words, the negative electrode-side busbar 52 is arranged side by side with the positive electrode-side busbar 51 with the gap G therebetween.

The gap G in the present embodiment has the same dimension as a gap G formed between the P-type terminal 431 and the N-type terminal 432.

An insulation distance (a spatial distance and a creepage distance) is secured in the gap G so that a current flowing through the positive electrode-side busbar 51 does not flow to the negative electrode-side busbar 52 or a current flowing through the negative electrode-side busbar 52 does not flow to the positive electrode-side busbar 51.

The insulation distance in the present embodiment is desirably, for example, 1 mm or more and 10 mm or less.

As illustrated in FIG. 3, the positive electrode-side busbar 51 includes a first main body portion 510 and a first cutout portion 511.

The first main body portion 510 in the present embodiment has a columnar shape extending in one direction between the capacitor 3 and the power module 40.

The first main body portion 510 includes a first bottom surface 510a abutting on the P-type terminal 431 and a first opposing surface 510b rising from the first bottom surface 510a.

In the present embodiment, the first bottom surface 510a and the first opposing surface 510b are perpendicular to each other.

The term "perpendicular" in the present embodiment refers to a substantially perpendicular state, and a slight manufacturing error and a design tolerance are allowed.

The first bottom surface 510a is integrally connected to the P-type terminal 431 by, for example, welding.

The first cutout portion 511 is disposed in the first main body portion 510 on a side opposite to the first bottom surface 510a and the first opposing surface 510b.

Here, the first cutout portion 511 is disposed so as to cut out, in a triangular prism shape in the direction in which the base material X extends, one corner disposed on a side opposite to the first bottom surface 510a forming a bottom surface of a base material X and the first opposing surface 510b forming a side surface of the base material X among four corners of the base material X forming a quadrangular prism shape forming the first main body portion 510.

A first inclined surface 510c that connects an end edge of the first bottom surface 510a and an end edge of the first opposing surface 510b to each other is formed in the first main body portion 510 by the first cutout portion 511.

Therefore, in the present embodiment, the first main body portion 510 is formed in a triangular prism shape having a right-angled triangular cross section by the first bottom surface 510a, the first opposing surface 510b, and the first inclined surface 510c included in the first main body portion 510.

The "cross section" in the present embodiment means a plane obtained by cutting the first main body portion 510 along a plane orthogonal to the direction in which the first main body portion 510 extends.

The negative electrode-side busbar 52 includes a second main body portion 520 and a second cutout portion 521.

The second main body portion 520 in the present embodiment has a columnar shape extending in the same direction as the direction in which the first main body portion 510 extends between the capacitor 3 and the power module 40.

The second main body portion 520 includes a second bottom surface 520a abutting on the N-type terminal 432 and a second opposing surface 520b rising from the second bottom surface 520a.

In the present embodiment, the second bottom surface 520a and the first opposing surface 510b are perpendicular to each other.

The second bottom surface 520a is integrally connected to the P-type terminal 431 by, for example, welding.

The second opposing surface 520b is disposed in parallel to and opposed to the first opposing surface 510b with the gap G therebetween.

The second cutout portion 521 is disposed in the second main body portion 520 on a side opposite to the second bottom surface 520a and the second opposing surface 520b.

Here, the second cutout portion 521 is disposed so as to cut out, in a triangular prism shape in the direction in which the base material X extends, one corner disposed on a side opposite to the second bottom surface 520a forming a bottom surface of a base material X and the second opposing surface 520b forming a side surface of the base material X among four corners of the base material X forming a quadrangular prism shape forming the second main body portion 520.

A second inclined surface 520c that connects an end edge of the second bottom surface 520a and an end edge of the second opposing surface 520b to each other is formed in the second main body portion 520 by the second cutout portion 521.

Therefore, in the present embodiment, the second main body portion 520 is formed in a triangular prism shape having a right-angled triangular cross section by the second bottom surface 520a, the second opposing surface 520b, and the second inclined surface 520c included in the second main body portion 520.

Here, a dimension of the first opposing surface 510b and the second opposing surface 520b in the direction perpendicular to the first bottom surface 510a and the second bottom surface 520a, respectively, is H, a dimension of the first bottom surface 510a and the second bottom surface 520a in the direction in which the first opposing surface 510b and the second opposing surface 520b are opposed is W, and the following expression (i) is established.

$$0.2 \leqq H/W \leqq 1 \cdots (i)$$

Actions and Effects

A current input from the capacitor 3 to the front surface pattern 421 through the positive electrode-side busbar 51 and the P-type terminal 431 each as the positive electrode is converted by the power semiconductor element 422 and then used for rotation of a motor or the like (load) provided outside the power conversion device 100 through the external output conductor 44.

The current used for the rotation of the motor or the like flows into the front surface pattern 421 again through the external output conductor 44, is converted by the power semiconductor element 422, and then returns to the capacitor 3 through the N-type terminal 432 and the negative electrode-side busbar 52 each as the negative electrode.

At this time, the positive electrode-side busbar 51 and the negative electrode-side busbar 52 are arranged side by side with the gap G therebetween, and a flow direction of the current flowing through the positive electrode-side busbar 51 and a flow direction of the current flowing through the negative electrode-side busbar 52 are opposite to each other.

This causes a magnetic flux generated in the positive electrode-side busbar 51 and a magnetic flux generated in the negative electrode-side busbar 52 to be canceled each other.

Since the magnitude of the current flowing in the front surface pattern 421 is rapidly changed by the switching of the power semiconductor element 422 on the circuit board 42, densities of the magnetic fluxes generated in the positive electrode-side busbar 51 and the negative electrode-side busbar 52 are rapidly changed according to the change.

At this time, in the positive electrode-side busbar 51 and the negative electrode-side busbar 52, counter electromotive forces (eddy currents) that generate magnetic fluxes that cancel changes in the densities of the magnetic fluxes are also generated.

The above-described configuration can secure larger areas of the first opposing surface 510b of the first main body portion 510 and the second opposing surface 520b of the second main body portion 520 by the first cutout portion 511 disposed in the first main body portion 510 and the second cutout portion 521 disposed in the second main body portion 520 as compared with, for example, a connection conductor 5 having a flat plate shape (quadrangular prism).

That is, opposing areas of the first main body portion 510 and the second main body portion 520 can be increased.

This can increase amounts of magnetic fluxes that cancel each other between the positive electrode-side busbar 51 and the negative electrode-side busbar 52.

It is possible to secure large areas of the first opposing surface 510b of the first main body portion 510 and the second opposing surface 520b of the second main body portion 520 without changing cross-sectional areas and weights of the first main body portion 510 and the second main body portion 520.

Thus parasitic inductance generated in the connection conductor 5 can be reduced while suppressing an increase in size and weight of the connection conductor 5.

In the above embodiment, the configuration of the first main body portion 510 and the second main body portion 520 formed in the triangular prism shape having the right-angled triangular cross section has been described. However, a configuration is not limited to this configuration.

Hereinafter, shapes that the first main body portion 510 and the second main body portion 520 can have will be described in a plurality of modifications (modifications 1 to 3).

In the configuration described below, the above equation (i) is satisfied.

Modification 1

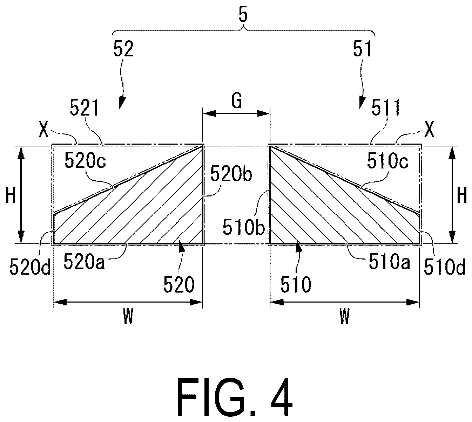

The positive electrode-side busbar 51 and the negative electrode-side busbar 52 may have configurations as illustrated in FIG. 4, for example.

In this case, the positive electrode-side busbar 51 includes the first main body portion 510 and the first cutout portion 511.

The first main body portion 510 includes the first bottom surface 510a abutting on the P-type terminal 431, the first opposing surface 510b rising from the first bottom surface 510a, and a first side surface 510d rising from the first bottom surface 510a and opposing a side opposite to the first opposing surface 510b in a state of being parallel to the first opposing surface 510b.

The first cutout portion 511 is disposed in the first main body portion 510 on a side opposite to the first bottom surface 510a and the first opposing surface 510b.

The first cutout portion 511 is disposed so as to cut out, in a triangular prism shape in the direction in which the base material X extends, one corner disposed on a side opposite to the first bottom surface 510a forming a bottom surface of a base material X and the first opposing surface 510b forming a side surface of the base material X among four corners of the base material X forming a quadrangular prism shape forming the first main body portion 510.

A first inclined surface 510c that connects an end edge of the first opposing surface 510b and an end edge of the first side surface 510d to each other is formed in the first main body portion 510 by the first cutout portion 511.

Therefore, the first main body portion 510 in this configuration is formed in a quadrangular prism shape having a trapezoidal cross section by the first bottom surface 510a, the first opposing surface 510b, the first side surface 510d, and the first inclined surface 510c included in the first main body portion 510.

Therefore, when viewing the cross section of the first main body portion 510, the first side surface 510d corresponds to an upper base of the trapezoidal shape, and the first opposing surface 510b corresponds to a lower base of the trapezoidal shape.

The negative electrode-side busbar 52 includes a second main body portion 520 and a second cutout portion 521.

The second main body portion 520 includes the second bottom surface 520a abutting on the N-type terminal 432, the second opposing surface 520b rising from the second bottom surface 520a, and a second side surface 520d rising from the second bottom surface 520a and opposing a side opposite to the second opposing surface 520b in a state of being parallel to the second opposing surface 520b.

The second opposing surface 520b is disposed in parallel to and opposed to the first opposing surface 510b with the gap G therebetween.

The second cutout portion 521 is disposed in the second main body portion 520 on a side opposite to the second bottom surface 520a and the second opposing surface 520b.

The second cutout portion 521 is disposed so as to cut out, in a triangular prism shape in the direction in which the base material X extends, one corner disposed on a side opposite to the second bottom surface 520a forming a bottom surface of a base material X and the second opposing surface 520b forming a side surface of the base material X among four corners of the base material X forming a quadrangular prism shape forming the second main body portion 520.

A second inclined surface 520c that connects an end edge of the second opposing surface 520b and an end edge of the second side surface 520d to each other is formed in the second main body portion 520 by the second cutout portion 521.

Therefore, the second main body portion 520 in this configuration is formed in a quadrangular prism shape having a trapezoidal cross section by the second bottom surface 520a, the second opposing surface 520b, the second side surface 520d, and the second inclined surface 520c included in the second main body portion 520.

Therefore, when viewing the cross section of the second main body portion 520, the second side surface 520d corresponds to an upper base of the trapezoidal shape, and the second opposing surface 520b corresponds to a lower base of the trapezoidal shape.

Modification 2

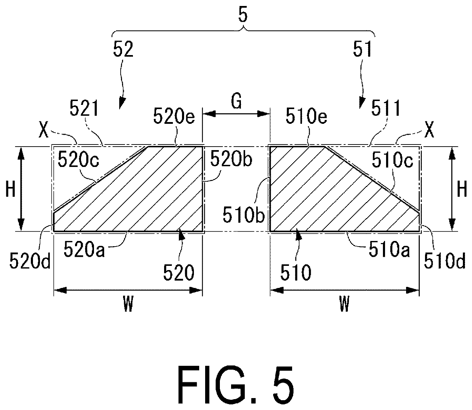

The positive electrode-side busbar 51 and the negative electrode-side busbar 52 may have configurations as illustrated in FIG. 5, for example.

In this case, the positive electrode-side busbar 51 includes the first main body portion 510 and the first cutout portion 511.

The first main body portion 510 includes the first bottom surface 510a abutting on the P-type terminal 431, the first opposing surface 510b rising from the first bottom surface 510a, the first side surface 510d rising from the first bottom surface 510a and opposing a side opposite to the first opposing surface 510b in a state of being parallel to the first opposing surface 510b, and a first upper surface 510e that is connected to the first opposing surface 510b and faces a side opposite to the first bottom surface 510a in a state of being parallel to the first bottom surface 510a.

The first cutout portion 511 is disposed in the first main body portion 510 on a side opposite to the first bottom surface 510a and the first opposing surface 510b.

The first cutout portion 511 is disposed so as to cut out, in a triangular prism shape in the direction in which the base material X extends, one corner disposed on a side opposite to the first bottom surface 510a forming a bottom surface of a base material X and the first opposing surface 510b forming a side surface of the base material X among four corners of the base material X forming a quadrangular prism shape forming the first main body portion 510.

A first inclined surface 510c that connects an end edge of the first upper surface 510e and an end edge of the first side surface 510d to each other is formed in the first main body portion 510 by the first cutout portion 511.

Therefore, the first main body portion 510 in this configuration is formed in a pentagonal prism shape having a pentagonal cross section by the first bottom surface 510a, the first opposing surface 510b, the first side surface 510d, the upper surface 510e, and the first inclined surface 510c included in the first main body portion 510.

The negative electrode-side busbar 52 includes a second main body portion 520 and a second cutout portion 521.

The second main body portion 520 includes the second bottom surface 520a abutting on the N-type terminal 432, the second opposing surface 520b rising from the second bottom surface 520a, the second side surface 520d rising from the second bottom surface 520a and opposing a side opposite to the second opposing surface 520b in a state of being parallel to the second opposing surface 520b, and a second upper surface 520e that is connected to the second opposing surface 520b and faces a side opposite to the second bottom surface 520a in a state of being parallel to the second bottom surface 520a.

The second opposing surface 520b is disposed in parallel to and opposed to the first opposing surface 510b with the gap G therebetween.

The second cutout portion 521 is disposed in the second main body portion 520 on a side opposite to the second bottom surface 520a and the second opposing surface 520b.

The second cutout portion 521 is disposed so as to cut out, in a triangular prism shape in the direction in which the base material X extends, one corner disposed on a side opposite to the second bottom surface 520a forming a bottom surface of a base material X and the second opposing surface 520b forming a side surface of the base material X among four corners of the base material X forming a quadrangular prism shape forming the second main body portion 520.

A second inclined surface 520c that connects an end edge of the second upper surface 520e and an end edge of the second side surface 520d to each other is formed in the second main body portion 520 by the second cutout portion 521.

Therefore, the second main body portion 520 in this configuration is formed in a pentagonal prism shape having a pentagonal cross section by the second bottom surface 520a, the second opposing surface 520b, the second side surface 520d, the second upper surface 520e, and the second inclined surface 520c included in the second main body portion 520.

Modification 3

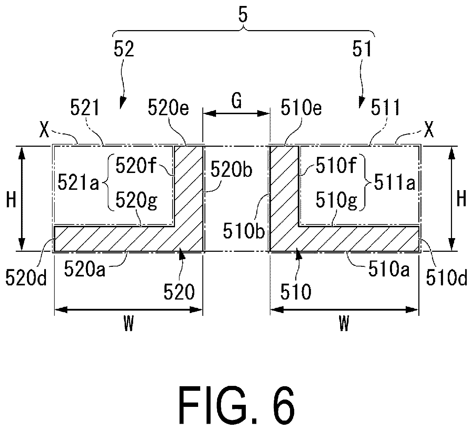

The positive electrode-side busbar 51 and the negative electrode-side busbar 52 may have configurations as illustrated in FIG. 6, for example.

In this case, the positive electrode-side busbar 51 includes the first main body portion 510 and the first cutout portion 511.

The first main body portion 510 includes the first bottom surface 510a abutting on the P-type terminal 431, the first opposing surface 510b rising from the first bottom surface 510a, the first side surface 510d rising from the first bottom surface 510a and opposing a side opposite to the first opposing surface 510b in a state of being parallel to the first opposing surface 510b, and the first upper surface 510e that is connected to the first opposing surface 510b and faces a side opposite to the first bottom surface 510a in a state of being parallel to the first bottom surface 510a.

The first cutout portion 511 is disposed in the first main body portion 510 on a side opposite to the first bottom surface 510a and the first opposing surface 510b.

The first cutout portion 511 is disposed so as to cut out, in a quadrangular prism shape in the direction in which the base material X extends, one corner disposed on a side opposite to the first bottom surface 510a forming a bottom surface of a base material X and the first opposing surface 510b forming a side surface of the base material X among four corners of the base material X forming a quadrangular prism shape forming the first main body portion 510.

A first cut surface 511a that connects an end edge of the first upper surface 510e and an end edge of the first side surface 510d to each other is formed in the first main body portion 510 by the first cutout portion 511.

The first cut surface 511a includes a first opposite surface 510f that is connected to the first upper surface 510e and faces a side opposite to the first opposing surface 510b in a state of being parallel to the first opposing surface 510b, and a first front surface 510g that connects the first opposite surface 510f and the first side surface 510d to each other and faces a side opposite to the first bottom surface 510a in a state of being parallel to the first bottom surface 510a.

Therefore, the first main body portion 510 in this configuration is formed in a hexagonal columnar shape having an L-shaped cross section by the first bottom surface 510a, the first opposing surface 510b, the first side surface 510d, and the first cut surface 511a included in the first main body portion 510.

The negative electrode-side busbar 52 includes a second main body portion 520 and a second cutout portion 521.

The second main body portion 520 includes the second bottom surface 520a abutting on the N-type terminal 432, the second opposing surface 520b rising from the second bottom surface 520a, the second side surface 520d rising from the second bottom surface 520a and opposing a side opposite to the second opposing surface 520b in a state of being parallel to the second opposing surface 520b, and a second upper surface 520e that is connected to the second opposing surface 520b and faces a side opposite to the second bottom surface 520a in a state of being parallel to the second bottom surface 520a.

The second opposing surface 520b is disposed in parallel to and opposed to the first opposing surface 510b with the gap G there between.

The second cutout portion 521 is disposed in the second main body portion 520 on a side opposite to the second bottom surface 520a and the second opposing surface 520b.

The second cutout portion 521 is disposed so as to cut out, in a quadrangular prism shape in the direction in which the base material X extends, one corner disposed on a side opposite to the second bottom surface 520a forming a bottom surface of a base material X and the second opposing surface 520b forming a side surface of the base material X among four corners of the base material X forming a quadrangular prism shape forming the second main body portion 520.

A second cut surface 521a that connects an end edge of the second upper surface 520e and an end edge of the second side surface 520d to each other is formed in the second main body portion 520 by the second cutout portion 521.

The second cut surface 521a includes a second opposite surface 520f that is connected to the second upper surface 520e and faces a side opposite to the second opposing surface 520b in a state of being parallel to the second opposing surface 520b, and a second front surface 520g that connects the second opposite surface 520f and the second side surface 520d to each other and faces a side opposite to the second bottom surface 520a in a state of being parallel to the second bottom surface 520a.

Therefore, the second main body portion 520 in this configuration is formed in a hexagonal columnar shape having an L-shaped cross section by the second bottom surface 520a, the second opposing surface 520b, the second side surface 520d, and the second cut surface 521a included in the second main body portion 520.

A plurality of examples of the shapes that the first main body portion 510 and the second main body portion 520 can have has been described above.

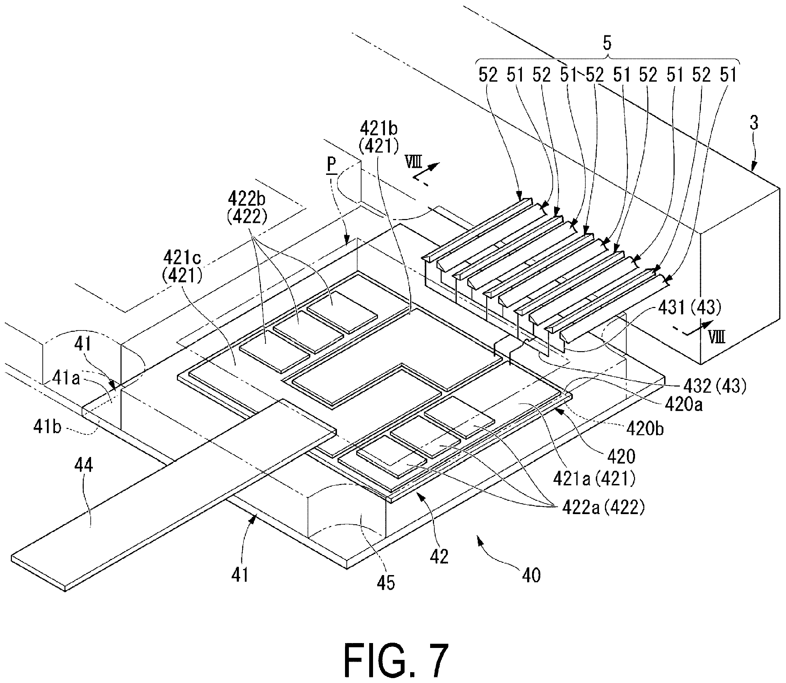

Instead of the configuration of the connection conductor 5 described above, as illustrated in FIG. 7, the connection conductor 5 includes, in accordance with the claimed invention, a plurality of the pairs of the positive electrode-side busbar 51 and the negative electrode-side busbar 52.

In the present configuration, five pairs of the positive electrode-side busbar 51 and the negative electrode-side busbar 52 are exemplified.

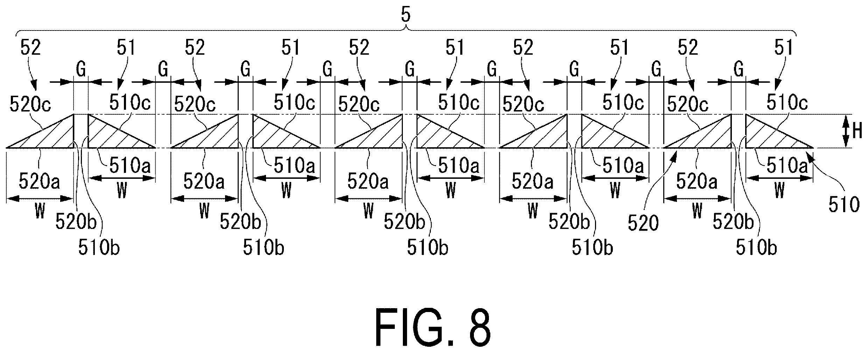

At this time, as illustrated in FIG. 8, the plurality of pairs of the positive electrode-side busbar 51 and the negative electrode-side busbar 52 are arranged side by side at equal intervals in the direction in which the first opposing surface 510b and the second opposing surface 520b are opposed to each other.

The pair of the positive electrode-side busbar 51 and the negative electrode-side busbar 52 are arranged side by side with a gap G therebetween, and the insulation distance is secured between the pair of the positive electrode-side busbar 51 and the negative electrode-side busbar 52.

Although detailed illustration is omitted, as illustrated in FIG. 7, each positive electrode-side busbar 51 is connected to the first front surface pattern 421a through the P-type terminal 431 (indicated by a solid line), and each negative electrode-side busbar 52 is connected to the second front surface pattern 421b through the N-type terminal 432 (indicated by a solid line).

According to the above configuration in accordance with the claimed invention, the connection conductor 5 is constituted by the plurality of pairs of the positive electrode-side busbar 51 and the negative electrode-side busbar 52.

Accordingly, as compared with a case where the connection conductor 5 is a pair of the positive electrode-side busbar 51 and the negative electrode-side busbar 52, the current path is divided into a plurality of paths, and the total opposing areas of the first opposing surface 510b and the second opposing surface 520b in the positive electrode-side busbar 51 and the negative electrode-side busbar 52 can be increased.

Thus, the parasitic inductance generated in the connection conductor 5 can be further reduced.

FIGS. 7 and 8 illustrate a case where the first main body portion 510 of the positive electrode-side busbar 51 and the second main body portion 520 of the negative electrode-side busbar 52 each have the triangular prism shape, but a configuration is not limited to this configuration.

That is, the positive electrode-side busbar 51 and the negative electrode-side busbar 52 may have the configurations described in modifications 1 to 3.

In the above embodiment, the first bottom surface 510a of the first main body portion 510 is integrally connected to the P-type terminal 431 and the second bottom surface 520a of the second main body portion 520 is connected to the N-type terminal 432 by welding. However, a configuration is not limited to this configuration.

The first main body portion 510 and the P-type terminal 431, and the second main body portion 520 and the N-type terminal 432 may be connected to each other by a fastening member or the like including a bolt and a nut.

The first cutout portion 511 is disposed in a portion of the first main body portion 510.

The second cutout 521 is also disposed in a portion of the second main body portion 520.

The configurations of the first main body portion 510 and the second main body portion 520 are not limited to the above, and for example, in the first main body portion 510 and the second main body portion 520, only a portion where the fastening member is disposed and connected to the main terminal portion 43 may be formed in a flat plate shape.

That is, the first cutout portion 511 may be disposed in at least part of the first main body portion 510 on a side opposite to the first bottom surface 510a and the first opposing surface 510b, and the second cutout portion 521 may be disposed in at least part of the second main body portion 520 on a side opposite to the second bottom surface 520a and the second opposing surface 520b.

In the embodiment, the configuration in which the first surface 420a and the second surface 420b of the base plate 41 are respectively parallel to the first surface 420a and the second surface 420b of the insulating plate 420 in the back-to-back relationship has been described. However, a configuration is not limited to this configuration and may have a slightly inclined configuration.

In the above embodiment, the configuration of the power conversion device 100 in which the power conversion unit 4 is a six-in-one module including three power modules 40 has been described. However, a configuration is not limited thereto.

For example, in the power conversion device 100, the power conversion unit 4 may be a two-in-one module including one power module 40.

In the above embodiment, the inverter has been described as an example of the power conversion device 100. However, the power conversion device 100 is not limited to the inverter.

The power conversion device 100 may be a device that performs power conversion by the power semiconductor element 422, such as a converter or a combination of an inverter and a converter.

When the power conversion device 100 is the converter, an AC voltage may be input from an external input power supply (not illustrated) to the external output conductor 44, the power semiconductor element 422 on the circuit board 42 may convert the AC voltage into a DC voltage, and the DC voltage from the power semiconductor element 422 may be output to the outside of the power conversion device 100 through the main terminal portion 43 and the connection conductor 5.

Industrial Applicability

According to the present invention, a power conversion device that can reduce parasitic inductance generated in a connection conductor while suppressing an increase in size and weight of the connection conductor can be provided.

Reference Signs List

    1 Casing
    1a Input-side side surface
    1b Output-side side surface
    2 External Input Conductor
    3 Capacitor
    4 Power conversion unit
    5. Connection conductor
    6 Cooling device
    40 Power module
    41 Base plate
    41a Main surface
    41b Back surface
    42 Circuit board
    43 Main terminal portion
    44 External output conductor
    45 Reinforcing portion
    51 Positive electrode-side busbar
    52 Negative electrode-side busbar
    100 Power conversion device
    420 Insulating plate
    420a First surface
    420b Second surface
    421 Front surface pattern
    421a First front surface pattern
    421b Second front surface pattern
    421c Third front surface pattern

422 Power semiconductor element
422a First power semiconductor element
422b Second power semiconductor element
431 P-type terminal
431a, 432a Other end portion
431b, 432b One end portion
432 N-type terminal
510 First main body portion
510a First bottom surface
510b First opposing surface
510c First inclined surface
510d First side surface
510e First upper surface
510f First opposite surface
510g First front surface
511 First cutout portion
511a First cut surface
520 Second main body portion
520a Second bottom surface
520b Second opposing surface
520c Second inclined surface
520d Second side surface
520e Second upper surface
520f Second opposite surface
520d Second front surface
521 Second cutout portion
521a Second cut surface
G Gap
P Potting space
X Base material

## Claims

**1.** A power conversion device, comprising:

a capacitor (3) to which DC power is supplied;
a power module (40) configured to convert a DC voltage from the capacitor into an AC voltage and output the AC voltage; and
a connection conductor (5) including a positive electrode-side busbar (51) configured to connect the capacitor and a P-type terminal (431) of the power module and a negative electrode-side busbar (52) having a shape identical to a shape of the positive electrode-side busbar, symmetrically arranged side by side with the positive electrode-side busbar in pairs with a gap (G) therebetween, and configured to connect the capacitor and an N-type terminal (432) of the power module, wherein
the positive electrode-side busbar (51) includes a first main body portion (510) including a first bottom surface (510a) abutting on the P-type terminal (431) and a first opposing surface (510b) rising from the first bottom surface and a first cutout portion (511) disposed in at least part of the first main body portion on a side opposite to the first bottom surface and the first opposing surface, and

the negative electrode-side busbar (52) includes

a second main body portion (520) including a second bottom surface (520a) abutting on the N-type terminal (432) and a second opposing surface (520b) rising from the second bottom surface and disposed in parallel to and opposed to the first opposing surface (510b) with a gap (G) therebetween,

a second cutout portion (521) disposed in at least part of the second main body portion on a side opposite to the second bottom surface and the second opposing surface,

the connection conductor (5) includes a plurality of pairs of the positive electrode-side busbar (51) and the negative electrode-side busbar (52), and

the plurality of pairs of the positive electrode-side busbar and the negative electrode-side busbar are arranged side by side at equal intervals in a direction in which the first opposing surface (510b) and the second opposing surface (520b) are opposed to each other.

2.  The power conversion device according to claim 1, wherein

a dimension of the first opposing surface (510b) in a direction perpendicular to the first bottom surface (510a) is H,

a dimension of the first bottom surface in a direction in which the first opposing surface and the second opposing surface (520b) are opposed to each other is W, and

$$0.2 < H/W < 1$$

is satisfied.

**Patentansprüche**

1.  Leistungsumwandlungsvorrichtung, umfassend:

einen Kondensator (3), dem DC-Leistung zugeführt wird;

ein Leistungsmodul (40), das konfiguriert ist, eine DC-Spannung von dem Kondensator in eine AC-Spannung umzuwandeln und die AC-Spannung auszugeben; und

einen Verbindungsleiter (5), der eine Positive-Elektrodenseite-Sammelschiene (51), die konfiguriert ist, den Kondensator und einen P-Typ-Anschluss (431) des Leistungsmoduls zu verbinden, und eine Negative-Elektrodenseite-Sammelschiene (52) beinhaltet, die eine Form identisch zu einer Form der Positive-Elektrodenseite-Sammelschiene aufweist, symmetrisch Seite an Seite paarweise mit der Positive-Elektrodenseite-Sammelschiene mit einem Spalt (G) dazwischen angeordnet ist, und konfiguriert ist, den Kondensator und einen N-Typ-Anschluss (432) des Leistungsmoduls zu verbinden, wobei die Positive-Elektrodenseite-Sammelschiene (51) einen ersten Hauptkörperabschnitt (510), der eine erste Bodenfläche bzw. -oberfläche (510a), die an dem P-Typ-Anschluss (431) anliegt, und eine erste gegenüberliegende Fläche bzw. Oberfläche (510b), die sich von der ersten Bodenfläche erhebt, und einen ersten Ausschnittabschnitt (511) beinhaltet, der in zumindest einem Teil des ersten Hauptkörperabschnitts auf einer Seite gegenüberliegend zu der ersten Bodenfläche und der ersten gegenüberliegenden Fläche angeordnet ist, und wobei die Negative-Elektrodenseite-Sammelschiene (52) einen zweiten Hauptkörperabschnitt (520), der eine zweite Bodenfläche (520a), die an dem N-Typ-Anschluss (432) anliegt, und eine zweite gegenüberliegende Fläche (520b), die sich von der zweiten Bodenfläche erhebt und parallel zu und entgegengesetzt zu der ersten gegenüberliegenden Fläche (510b) mit einem Spalt (G) dazwischen angeordnet ist, und einen zweiten Ausschnittabschnitt (521) beinhaltet, der in zumindest einem Teil des zweiten Hauptkörperabschnitts auf einer Seite gegenüberliegend zu der zweiten Bodenfläche und der zweiten gegenüberliegenden Fläche angeordnet ist, wobei der Verbindungsleiter (5) eine Mehrzahl von Paaren der Positive-Elektrodenseite-Sammelschiene (51) und der Negative-Elektrodenseite-Sammelschiene (52) beinhaltet, und die Mehrzahl von Paaren der Positive-Elektrodenseite-Sammelschiene und der Negative-Elektrodenseite-Sammelschiene Seite an Seite in gleichen Abständen in einer Richtung angeordnet sind, in der die erste gegenüberliegende Fläche (510b) und die zweite gegenüberliegende Fläche (520b) einander gegenüberliegen.

2.  Leistungsumwandlungsvorrichtung nach Anspruch 1, wobei eine Abmessung der ersten gegenüberliegenden Fläche (510b) in einer Richtung senkrecht zu der ersten Bodenfläche (510a) H beträgt, eine Abmessung der ersten Bodenfläche in einer Richtung, in der die erste gegenüberliegende Fläche und die zweite gegenüberliegende Fläche (520b) einander gegenüberliegen, W beträgt, und 0,2 < H/W < 1 erfüllt ist.

## Revendications

**1.** Dispositif de conversion de puissance, comprenant :

un condensateur (3) auquel une alimentation CC est fournie ;
un module de puissance (40) configuré pour convertir une tension CC du condensateur en une tension CA et délivrer en sortie la tension CA ; et
un conducteur de connexion (5) comportant une barre omnibus côté électrode positive (51) configurée pour connecter le condensateur et une borne de type P (431) du module de puissance et
une barre omnibus côté électrode négative (52) présentant une forme identique à une forme de la barre omnibus côté électrode positive, agencée symétriquement côte à côte avec la barre omnibus côté électrode positive par paires avec un espace (G) entre elles, et configurée pour connecter le condensateur et une borne de type N (432) du module de puissance, la barre omnibus côté électrode positive (51) comportant
une première partie de corps principal (510) comportant une première surface inférieure (510a) en butée sur la borne de type P (431) et une première surface opposée (510b) qui s'élève à partir de la première surface inférieure et
une première partie découpée (511) disposée dans au moins une part de la première partie de corps principale sur un côté opposé à la première surface inférieure et à la première surface opposée, et
la barre omnibus côté électrode négative (52) comporte
une seconde partie de corps principal (520) comportant une seconde surface inférieure (520a) en butée sur la borne de type N (432) et une seconde surface opposée (520b) qui s'élève à partir de la seconde surface inférieure et disposée parallèlement et opposée à la première surface opposée (510b) avec un espace (G) entre elles,
une seconde partie découpée (521) disposée dans au moins une part de la seconde partie de corps principal sur un côté opposé à la seconde surface inférieure et à la seconde surface opposée,
le conducteur de connexion (5) comporte une pluralité de paires de la barre omnibus côté électrode positive (51) et de la barre omnibus côté électrode négative (52), et
la pluralité de paires de la barre omnibus côté électrode positive et de la barre omnibus côté électrode négative sont agencées côte à côte à intervalles égaux dans une direction dans laquelle la première surface opposée (510b) et la seconde surface opposée (520b) sont opposées l'une à l'autre.

**2.** Dispositif de conversion de puissance selon la revendication 1, dans lequel

une dimension de la première surface opposée (510b) dans une direction perpendiculaire à la première surface inférieure (510a) est H,
une dimension de la première surface inférieure dans une direction dans laquelle la première surface opposée et la seconde surface opposée (520b) sont opposées l'une à l'autre est W.
et

$$0,2 < H/W < 1$$

est satisfait.

FIG. 1

FIG. 2

FIG. 3

FIG. 4

FIG. 5

FIG. 6

FIG. 7

EP 4 498 591 B1

FIG. 8

EP 4 498 591 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022075380 A
- JP 2002119069 A
- WO 2020021881 A